**Europäisches Patentamt**

(19) **European Patent Office**

**Office européen des brevets**

(11) Veröffentlichungsnummer: **0 118 689**

**A2**

(12) # EUROPÄISCHE PATENTANMELDUNG

(21) Anmeldenummer: **84100641.4**

(51) Int. Cl.³: **H 05 K 13/00**

(22) Anmeldetag: **21.01.84**

(30) Priorität: **05.02.83 DE 3303951**

(43) Veröffentlichungstag der Anmeldung:
**19.09.84 Patentblatt 84/38**

(84) Benannte Vertragsstaaten:
**CH DE FR GB IT LI SE**

(71) Anmelder: **International Standard Electric Corporation**
**320 Park Avenue**
**New York New York 10022(US)**

(84) Benannte Vertragsstaaten:
**CH FR GB IT LI SE**

(71) Anmelder: **Standard Elektrik Lorenz Aktiengesellschaft**
**Hellmuth-Hirth-Strasse 42**
**D-7000 Stuttgart 40(DE)**

(84) Benannte Vertragsstaaten:
**DE**

(72) Erfinder: **Kuehn, Volker**
**Bülowstrasse 15**
**D-7530 Pforzheim(DE)**

(72) Erfinder: **Rothfuss, Werner**
**Carl-Peter-Strasse 40**
**D-7015 Korntal-Münchingen 1(DE)**

(72) Erfinder: **Widmaier, Richard**
**Teckstrasse 4**
**D-7014 Kornwestheim(DE)**

(74) Vertreter: **Gähr, Hans-Dieter et al,**
**c./o.Standard Elektrik Lorenz AG Patent- und**
**Lizenzwesen Postfach 300 929 Kurze Strasse 8**
**D-7000 Stuttgart 30(DE)**

(54) **Bestückungstisch zum manuellen Bestücken von Schaltungsträgern.**

(57) Zum manuellen Bestücken von Schaltungsträgern (Leiterplatten, Hybridschaltungen oder dergl.) mit oberflächenmontierbaren elektrischen Bauelementen mit Hilfe eines Bestückungstisches (1), der mit einer Aufnahmeeinrichtung für den Schaltungsträger (5), einem programmierbaren Kleberdosiergerät (6) und einer programmierbaren Bauelemente-Bereitstellungseinrichtung (8, 9) ausgestattet ist, wird die Aufnahmeeinrichtung mit dem Schaltungsträger (5) unter einer Abdeckung (2) des Bestückungstisches (1) koordinatenmäßig in eine zentral gelegene Position zum automatischen Aufbringen des Klebers mittels des Kleberdosiergerätes (6) und in eine zentral gelegene Bestückungsposition zum manuellen Plazieren der Bauelemente bewegt, wobei die Kleberauftragsposition und die Bestückungsposition innerhalb eines Fensters (3, 4) der Abdeckung (2) liegen, durch das die einzelnen Bauelemente-Bestückungsorte auf dem Schaltungsträger (5) in programmierter Reihenfolge von oben zugänglich sind.

*Fig. 1*

/

V.Kühn-W.Rothfuß-R.Widmaier 1-1-1

Bestückungstisch zum manuellen Bestücken
von Schaltungsträgern

Die Erfindung betrifft einen Bestückungstisch nach dem
Oberbegriff des Patentanspruches 1.

Den Forderungen nach rationeller Fertigung, höherer
Packungsdichte und kleineren Abmessungen elektronischer
Schaltkreise kommen besonders die Bauelemente ohne Anschlußdrähte bzw. -beine (Leadless Components) wie Chips
und MELFs (Metal Electrode Face Bonding) entgegen. In
diesen Bauformen lassen sich sowohl aktive als auch
passive Bauelemente herstellen. Derartige Bauelemente sind
bisher vorwiegend in Hybridschaltungen verwendet worden.
Im Hinblick darauf, daß die Miniaturisierung immer weiter
schreitet und der optimale Nutzen von integrierten
Schaltkreisen erst dann erreicht wird, wenn auch die dazugehörigen passiven Bauelemente kleiner werden, haben die
Bauelemente-Hersteller für das Bestücken von Leiterplatten
Bauelemente in ähnlicher Bauweise entwickelt.

Bedingt durch geringe Stückzahlen von Bauelementen auf
Hybridschaltungen (ca. 5 bis 20 Stück) können diese nach
einer Vorlage von Hand bestückt werden. Bei Leiterplatten
mit hohen Bauelemente-Stückzahlen ist das Bestücken nach

*𝓁*

einer Vorlage aufgrund der hohen Fehlerraten nicht vertretbar. Es müssen daher angepaßte Bestückungstechnologien entwickelt werden.

Zum manuellen Bestücken von Leiterplatten mit anschlußlosen Bauelementen ist es bekannt, die Bauelemente-Bestückungsorte einer Leiterplatte, die in eine Aufnahmeeinrichtung eines Bestückungstisches eingespannt ist, nacheinander mittels einer programmierten wandernden Lichtpunktanzeige anzuleuchten. Mit einem mit einer Vakuumpinzette versehenen Manipulator wird ein bestimmtes Bauelement aus einem Bauelementebehälter entnommen und an einem Kleberdosiergerät vorbeigeführt, wo es mit Klebstoff in einer automatisch dosierten Menge benetzt wird. Danach wird das Bauelement mit dem Manipulator von Hand an den jeweils angeleuchteten Bestückungsort transportiert und dort plaziert. (Firmenprospekt Royonic November 1981). Dieses Bestückungsverfahren ist für kleine Stückzahlen gut geeignet, hat jedoch den Nachteil, daß die bereits plazierten Bauelemente durch Unachtsamkeit der Bestückungsperson bei nachfolgenden Bestückungsvorgängen verschoben werden können.

Weiterhin ist eine vollautomatische Bestückungsmaschine zum Bestücken von Leiterplatten mit oberflächenmontierbaren Bauelementen bekannt, bei der an einer Kleberauftragsstation zunächst alle Bauelemente-Bestückungsorte einer Leiterplatte mit Kleber in programmierter Menge benetzt werden. Anschließend wird die Leiterplatte zu einer Bestückungsstation transportiert, wo mittels eines sogenannten Bestückungskopfes die in Magazinen bereitgestellten Bauelemente automatisch an den jeweiligen Bestückungsorten der Leiterplatte plaziert werden, während gleichzeitig die nächste Leiterplatte an der Kleberauftragsstation mit Kleber versorgt wird. Die Leiterplatten

J

V.Kühn 1-1-1

liegen in einer programmiert bewegbaren Aufnahmeeinrichtung, die die an der Kleberauftragsstation befindliche Leiterplatte und die an der Bestückungsstation befindlichen Leiterplatte jeweils gleichzeitig koordinatenmäßig bewegt und die kongruenten Bestückungsorte beider Leiterplatten in die Kleberauftrags- bzw. Bestückungsposition bringt. (Firmenprospekt Panasonic 8108). Dieses Bestückungssystem ist für große Stückzahlen gut geeignet, insbesondere wenn schaltungsgemäß eine Vielzahl gleichartiger Bauelemente auf eine Leiterplatte aufgebracht werden muß. Für kleine und mittlere Serien ist dieses System jedoch nicht wirtschaftlich verwendbar.

Der Erfindung liegt die Aufgabe zugrunde, einen Bestückungstisch für Schaltungsträger mit oberflächenmontierbaren Bauelementen zu schaffen, der bei der Fertigung von Klein- und Mittelserien wirtschaftlich einsetzbar ist und ein sicheres manuelles Bestücken des Schaltungsträgers ohne Gefährdung bereits plazierter Bauelemente erlaubt.

Diese Aufgabe wird erfindungsgemäß durch die im kennzeichnenden Teil des Patentanspruches 1 angegebenen Maßnahmen gelöst.

Durch die gleichbleibende Bestückungsposition ergibt sich eine bessere ergonomische und physiologische Arbeitsgestaltung, wodurch Bestückungsfehler vermieden werden. Bereits plazierte Bauelemente sind durch die Abdeckung sicher geschützt. Durch den automatischen Kleberauftrag steigt die Qualität hinsichtlich der Kleberpositionierung und -menge, wodurch die Qualität der Lötstellen beim nachfolgenden Lötvorgang positiv beeinflußt wird.

Vorteilhafte Ausgestaltungen des Gegenstandes des Patentanspruches 1 sind den Unteransprüchen zu entnehmen.

V.Kühn 1-1-1

Die Erfindung wird anhand von Zeichnungen beschrieben, die zwei Ausführungsbeispiele der Erfindung wie folgt zeigen:

Fig. 1    einen Bestückungstisch in schematischer räumlicher Darstellung;

Fig. 2    die Abdeckung des Bestückungstisches nach Fig. 1, von oben gesehen;

Fig. 3    einen Teil eines Schaltungsträgers, auf den mittels einer Kleberauftragsdüse ein Kleberpunkt gesetzt ist, von der Seite gesehen;.

Fig. 4    den Schaltungsträger nach Fig. 3 mit auf dem Kleberpunkt plaziertem Bauelement, von der Seite gesehen;

Fig. 5    einen weiteren Bestückungstisch in schematischer räumlicher Darstellung.

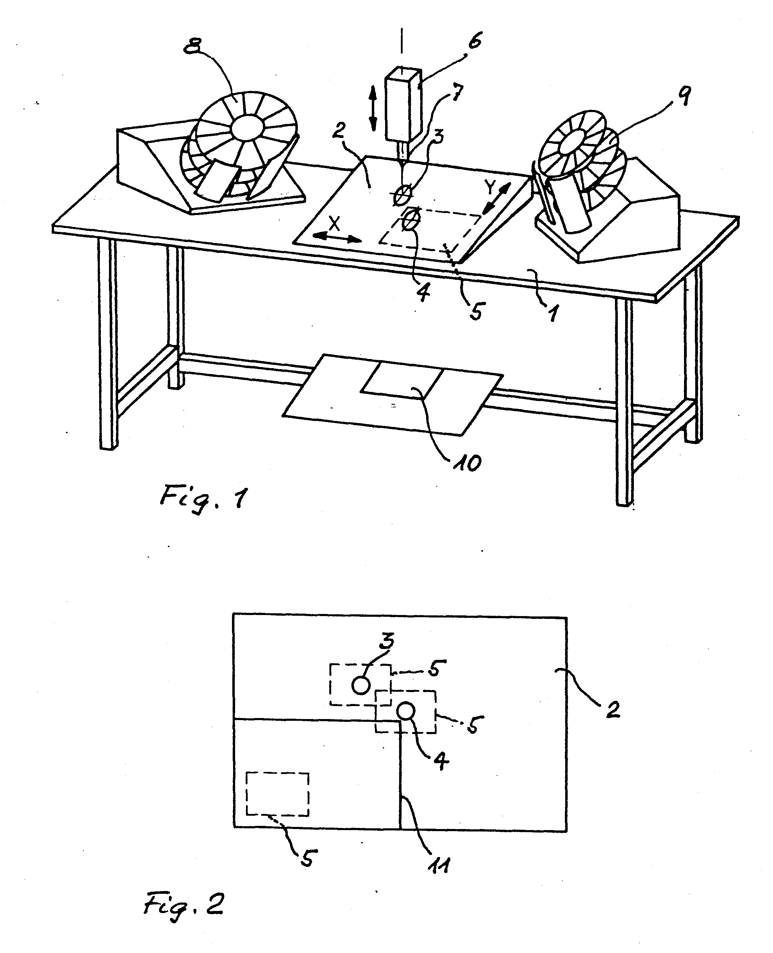

In Fig. 1 ist ein Bestückungstisch 1 dargestellt, der im mittleren Bereich seiner Arbeitsfläche eine Abdeckung 2 aus undurchsichtigem Material trägt. An zentraler Stelle hat die Abdeckung 2 zwei versetzt zueinander angeordnete Fenster 3 und 4, die jeweils einen Durchmesser von ca. 40 mm aufweisen. Im dargestellten Ausführungsbeispiel sind die Fenster 3 und 4 rund; sie können jedoch auch rechteckig, z.B. quadratisch, sein. Unter der Abdeckung 2 liegt ein Schaltungsträger 5 in einer nicht dargestellten Aufnahmeeinrichtung, die mit einer Kreuzschlittenmechanik gekoppelt ist, mit deren Hilfe der Schaltungsträger 5 unter der Abdeckung 2 des Bestückungstisches 1 koordinatenmäßig bewegbar ist, wie es durch die beiden Doppelpfeile X und Y angedeutet ist. Die Abdeckung 2 hat eine ergonomisch günstige Neigung von ca. 15 ° und der Schaltungsträger 5 wird in einer hierzu parallelen Ebene bewegt. Senkrecht über dem Fenster 3 ist ein Kleberdosiergerät 6 angeordnet, dessen Kleberauftragsdüse 7 auf die Mitte des Fensters 3 gerichtet ist. Das Kleberdosiergerät 6 bzw. die Kleberauftragsdüse 7 ist bis zur Berührung mit dem Schaltungsträger 5 absenkbar und zum Ausgleich von Höhentoleranzen des Schaltungsträger 5 federnd gelagert. Auf jeder Seite der Abdeckung 2 ist auf dem Bestückungstisch 1 jeweils eine Rundtellereinheit 8 bzw. 9 angeordnet, die mit jeweils drei drehbaren Rundtellern ausgestattet ist, in deren Fächern die zur Bestückung des Schaltungsträgers 5 vorgesehenen Bauelemente in programmierter Reihenfolge bereitgestellt werden. Ein in eine Fußstütze integrierter Fußschalter 10 dient zum Weiterschalten des Bestückungsprogrammes.

Die einzelnen Arbeitsvorgänge beim Bestücken eines Schaltungsträgers 5 können am besten unter Zuhilfenahme von Fig. 2 erläutert werden. Die hier in der Draufsicht dargestellte Abdeckung 2 weist einen hochklappbaren Teil 11 auf, der das Einlegen des Schaltungsträgers 5 in die in der Ausgangsstellung befindliche Aufnahmeeinrichtung ermöglicht. Nach dem Starten des Bestückungsprogrammes wird der Schaltungsträger 5 mit Hilfe der Kreuzschlittenmechanik automatisch in die Position zum Aufbringen des Klebers transportiert und zwar derart, daß der erste Bauelemente-Bestückungsort des Schaltungsträgers 5 senkrecht unter der Kleberauftragsdüse 7 des Kleberdosiergerätes 6 in der Mitte des Fensters 3 erscheint. Nun wird die Kleberauftragsdüse 7 automatisch abgesenkt und der erste Kleberpunkt auf den Schaltungsträger 5 gesetzt. Das Kleberdosiergerät 6 ist sowohl hinsichtlich der Klebermenge als auch hinsichtlich der Anzahl der Kleberpunkte pro Bestückungsort programmierbar, letzteres, falls für be-

V.Kühn 1-1-1

stimmte Bauelementegrößen oder -arten mehr als ein Kleber-punkt erforderlich ist. Für die folgenden Erläuterungen wird der Einfachheit halber jedoch weiterhin von einem Kleberpunkt pro Bauelement ausgegangen. Nach dem Setzen des ersten Kleberpunktes wird der Schaltungsträger 5 mit Hilfe der Kreuzschlittenmechanik automatisch in die Be-stückungsposition transportiert, so daß der mit Kleber versehene erste Bauelemente-Bestückungsort in der Mitte des Fensters 4 erscheint. Inzwischen hat die Bestückungs-person das von der Rundtellereinheit 8 oder 9 nach Pro-gramm bereitgestellte Bauelement ergriffen und kann es am ersten Bestückungsort des Schaltungsträger 5 plazieren. Mit dem Fußschalter 10 wird nun das Programm weitergeschal-tet und der zweite Bauelemente-Bestückungsort des Schal-tungsträgers 5 wird in die Position zum Aufbringen des Klebers unter dem Fenster 3 und nach dem automatischen Setzen des zweiten Kleberpunktes automatisch in die Bestückungsposition unter dem Fenster 4 transportiert, wo das zweite Bauelement manuell plaziert wird. Diese Vorgänge werden so lange wiederholt - wobei der Schaltungsträger 5 immer zwischen der Position zum Aufbringen des Klebers und der Bestückungsposition hin und her fährt -, bis alle Bau-elemente-Bestückungsorte des Schaltungsträgers 5 in der programmierten Reihenfolge mit Kleber versorgt und mit Bauelementen bestückt sind. Danach fährt die Aufnahmeein-richtung wieder in die Ausgangsstellung zurück und der erste Schaltungsträger kann nach dem Hochklappen des Teiles 11 entnommen und der nächste Schaltungsträger eingesetzt werden.

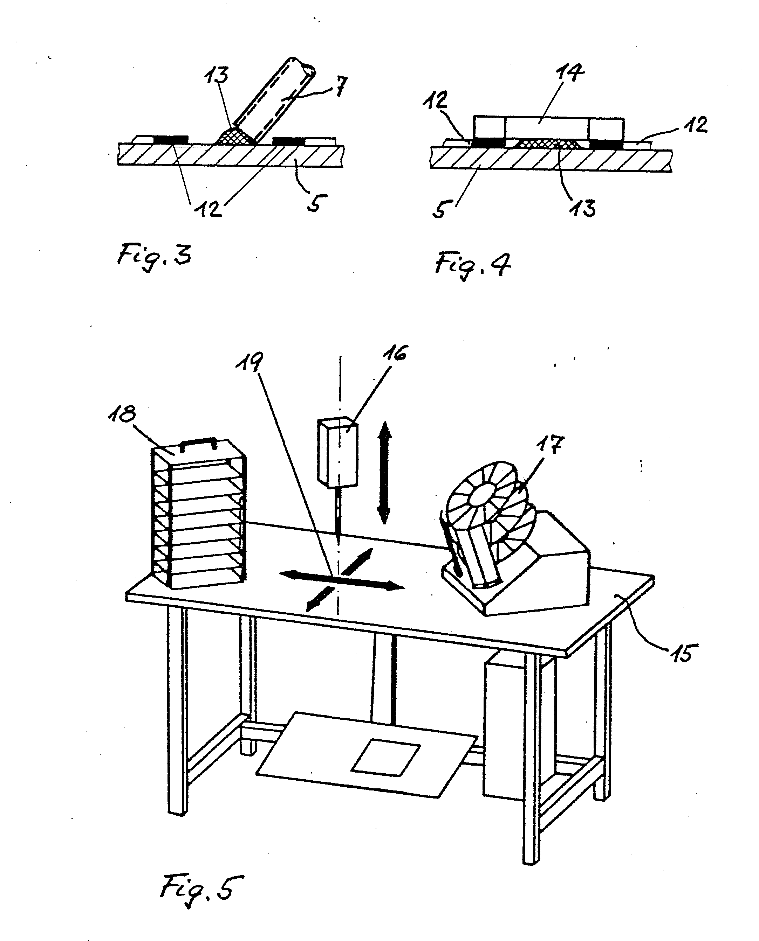

Die Fig. 3 zeigt einen Teil eines Schaltungsträger 5 mit Leiterbahnen 12, die blanke Anschlußflächen für Bauelemente ohne Anschlußdrähte bzw. -beine aufweisen. Die Kleberauf-tragsdüse 7 ist bis zur Berührung mit dem Schaltungsträger 5

V.Kühn 1-1-1

abgesenkt und hat einen Kleberpunkt 13 gesetzt. Wenn mit auf dem Schaltungsträger 5 aufsitzender Kleberauftragsdüse 7 gearbeitet wird, hat sich die dargestellte Neigung der Kleberauftragsdüse zur Ebene des Schaltungsträgers 5 von ca. 50 $^{\circ}$ als besonders günstig zum Setzen der Kleberpunkte 13 erwiesen. Die Hubrichtung der Kleberauftragsdüse 7 verläuft jedoch senkrecht.

In Fig. 4 ist ein Bauelement 14 auf dem Kleberpunkt 13 plaziert, so daß die Anschlußflächen des Bauelementes 14 auf den blanken Anschlußflächen der Leiterbahnen 12 liegen. Der Vollständigkeit halber sei erwähnt, daß ein mit derartigen Bauelementen bestückter Schaltungsträger zum Aushärten des Klebers in einem Ofen erwärmt wird und daß der Schaltungsträger anschließend eine Lötvorrichtung durchläuft, wobei die Anschlußflächen der Bauelemente und die des Schaltungsträgers stoffschlüssig miteinander verbunden werden.

In Fig. 5 ist ein weiterer Bestückungstisch 15 dargestellt, bei dem die Position zum automatischen Aufbringen des Klebers mittels des programmierbaren Kleberdosiergerätes 16 und die Bestückungsposition zusammenfallen. Die nicht dargestellte Abdeckung dieses Tisches weist daher nur ein Fenster auf, durch das sowohl das Aufbringen des Klebers als auch das Bestücken mit Bauelementen vorgenommen wird. Hierzu wird das Kleberdosiergerät 16 so weit angehoben oder zur Seite geschwenkt, daß die Bestückungsperson ungehindert arbeiten kann. Auf dem Bestückungstisch 15 ist beispielsweise nur eine Rundtellereinheit 17 vorhanden. Links vom mittleren Arbeitsbereich des Tisches steht ein Transportbehälter 18, in dem die bestückten Schaltungsträger abgelegt und zum Aushärteofen transportiert werden. Die Doppelpfeile 19 in der Ebene des Tisches deuten die koordinatenmäßige Bewegung des Schaltungsträgers mit Hilfe

V.Kühn 1-1-1

der programmierbaren Kreuzschlittenmechanik an. Der Bestückungstisch 15 nach Fig. 5 unterscheidet sich in seiner Arbeitsweise von dem vorstehend anhand der Fig. 1
und 2 beschriebenen Bestückungstisch 1 lediglich dadurch,
daß zwischen dem Kleberauftrag und der manuellen Bestückung eines bestimmten Bestückungsortes kein Transportschritt des Schaltungsträgers stattfindet.

Bei beiden Ausführungsbeispielen hat es sich als besonders
günstig erwiesen, wenn der Bauelemente-Bestückungsort auf
dem Schaltungsträger in der Bestückungsposition mittels
einer ortsfesten Lichtquelle punktförmig beleuchtet ist.
Durch den angeleuchteten Kleberpunkt wird der Bestückungsort für die Bestückungsperson deutlich angezeigt, insbesondere, wenn ein gefärbter Kleber verwendet wird oder
- beim Einsatz von farblosem Kleber - wenn die Lichtquelle
farbig ist, wie dies bei einer Laser-Lichtquelle der Fall
ist. Weiterhin ist bei beiden Ausführungsbeispielen in unmittelbarer Nähe der zentral gelegenen Bestückungsposition,
d.h. im Blickfeld der Bestückungsperson, eine Anzeigevorrichtung angeordnet, die z.B. mittels in verschiedenen
Richtungen aufleuchtender Pfeile die Bestückungsperson
auf die richtige Einbaulage gepolter Bauelemente hinweist.

V.Kühn-W.Rothfuß-R.Widmaier 1-1-1

Patentansprüche

1. Bestückungstisch (1) zum manuellen Bestücken von Schaltungsträgern (Leiterplatten, Hybridschaltungen oder dergl.) mit oberflächenmontierbaren elektrischen Bauelementen, mit einer Aufnahmeeinrichtung für den Schaltungsträger (5), einem programmierbaren Kleberdosiergerät (6) und einer programmierbaren Bauelemente-Bereitstellungseinrichtung (8, 9), dadurch gekennzeichnet, daß die Aufnahmeeinrichtung mit dem Schaltungsträger (5) unter einer Abdeckung (2) des Bestückungstisches (1) koordinatenmäßig bewegbar ist und daß eine zentral gelegene Position zum automatischen Aufbringen des Klebers mittels des Kleberdosiergerätes (6) und eine zentral gelegene Bestückungsposition vorgesehen sind, die innerhalb eines Fensters (3, 4) der Abdeckung (2) liegen, durch das die einzelnen Bauelemente-Bestückungsorte auf dem Schaltungsträger (5) in programmierter Reihenfolge von oben zugänglich sind.

2. Bestückungstisch nach Anspruch 1, dadurch gekennzeichnet, daß die Position zum automatischen Aufbringen des Klebers und die Bestückungsposition zusammenfallen.

ZT/P1-G/V

03.02.1983

V.Kühn 1-1-1

3. Bestückungstisch nach Anspruch 1, dadurch gekennzeichnet, daß die Position zum automatischen Aufbringen des Klebers und die Bestückungsposition versetzt zueinander liegen.

4. Bestückungstisch nach Anspruch 1, dadurch gekennzeichnet, daß die Aufnahmeeinrichtung für den Schaltungsträger (5) mit einer Kreuzschlittenmechanik gekoppelt ist.

5. Bestückungstisch nach Anspruch 1, dadurch gekennzeichnet, daß zumindest ein Teil (11) der Abdeckung (2) zum Einlegen oder Entnehmen des Schaltungsträgers (5) abnehmbar, hochklappbar oder verschiebbar ist.

6. Bestückungstisch nach Anspruch 1, dadurch gekennzeichnet, daß das Kleberdosiergerät (6) sowohl hinsichtlich der Klebermenge als auch hinsichtlich der Anzahl der Kleberpunkte pro Bestückungsort programmierbar ist.

7. Bestückungstisch nach Anspruch 1, dadurch gekennzeichnet, daß der Bestückungsort auf dem Schaltungsträger (5) in der Bestückungsposition mittels einer ortsfesten Lichtquelle punktförmig beleuchtbar ist.

8. Bestückungstisch nach Anspruch 1, dadurch gekennzeichnet, daß in unmittelbarer Nähe der zentral gelegenen Bestückungsposition eine Anzeigevorrichtung zum Hinweis auf die richtige Einbaulage gepolter Bauelemente angeordnet ist.

Fig. 1

Fig. 2

V.Kühn - W.Rothfuß - R.Widmaier 1-1

Fig. 3

Fig. 4

Fig. 5

V. Kühn - W. Rothfuß - R. Widmaier 1.